# EUROPÄISCHE PATENTSCHRIFT

(11) **EP 2 931 937 B1**
(45) Veröffentlichungstag und Bekanntmachung des Hinweises auf die Patenterteilung: **12.10.2016**
(21) Anmeldenummer: 13831822.5
(22) Anmeldetag: 12.12.2013
(51) Int. Cl.: C23C 26/00, C23C 14/02, C23C 14/16, B82Y 40/00

(54) **VERFAHREN ZUR HERSTELLUNG VON METALL-NANOPARTIKEL-ARRAYS**
METHOD OF PRODUCING METAL-NANOPARTICLE-ARRAYS
PROCÉDÉ DE FABRICATION DE RÉSEAUX DE NANOPARTICULES MÉTALLIQUES

(30) Priorität: 14.12.2012 DE 102012112299
(43) Veröffentlichungstag der Anmeldung: 21.10.2015
(73) Patentinhaber: Leibniz-Institut für Neue Materialien gemeinnützige GmbH, 66123 Saarbrücken (DE)
(72) Erfinder: BRODOCEANU, Daniel, 66123 Saarbrücken (DE); KRAUS, Tobias, 66111 Saarbrücken (DE); FANG, Cheng, Bellevue Heights, SA 5050 (AU); VÖLCKER, Nicolas Hans, Blackwood, SA 5051 (AU)
(74) Vertreter: Vièl, Christof
(86) Internationale Anmeldenummer: PCT/DE2013/100420
(87) Internationale Veröffentlichungsnummer: WO 2014/090229

(56) Entgegenhaltungen:
- WO-A1-2010/088726
- WO-A1-2012/057993
- US-A1- 2007 110 671
- US-A1- 2009 131 274
- BRODOCEANU D ET AL: "Paper;Fabrication of metal nanoparticle arrays by controlled decomposition of polymer particles;Fabrication of metal nanoparticle arrays by controlled decomposition of polymer particles", NANOTECHNOLOGY, IOP, BRISTOL, GB, Bd. 24, Nr. 8, 5. Februar 2013 (2013-02-05), Seite 85304, XP020241585, ISSN: 0957-4484, DOI: 10.1088/0957-4484/24/8/085304
- ARSENIY I. KUZNETSOV ET AL: "Laser Fabrication of Large-Scale Nanoparticle Arrays for Sensing Applications", ACS NANO, Bd. 5, Nr. 6, 3. Mai 2011 (2011-05-03), Seiten 4843-4849, XP055123446, ISSN: 1936-0851, DOI: 10.1021/nn2009112

## Beschreibung

Nanopartikel-Arrays (NP-Arrays) werden gewöhnlich mittels Photolithographie, Elektronenstrahllithografie, Nanoimprint oder kolloidaler Lithographie hergestellt.

Ein Nanopartikelarray ist hier eine regelmäßige Anordnung, z.B. in Form eines Gitters.

Sowohl in der Photolithographie als auch in der Elektronenstrahllithografie (E-Lithographie) werden Lacke verwendet, die mittels einer Maske entweder UV-Photonen oder einem Elektronenstrahl ausgesetzt ist, um ein gewünschtes Muster zu definieren. Nach dem lithographischen Prozess ergeben hinterher angewandte Behandlungen (wie beispielsweise Metallabscheidung, Lack-Auflösung, Annealing usw.) den endgültigen NP-Array.

Konventionelle kolloidale Lithographie beruht auf Metall, das zwischen den Sphären einer selbstorganisierten Monoschicht aufgebracht wird. Solche Muster können derart getempert werden, so dass beinahe dreieckige Inseln in abgerundete Metall-Nanopartikel konvertieren.

Für eine andere Herstellung von NP-Arrays werden sogenannte Kern-Schale (CS)-Teilchen verwendet, wobei diese einen Kern aus Metall-NP aufweisen, und der Kern wiederum durch eine Polymerhülle umschlossen ist.

Kern-Schale (CS)-Teilchen können durch konvektive Anordnung als dicht gepackte Monoschichten auf nahezu jeder glatten Oberfläche aufgebracht werden. Ihre Schalen werden nach dem Aufbringen thermisch zersetzt oder plasmageätzt, wonach die Metall-Nanopartikel-Kerne in einer zumeist regelmäßigen hexagonalen Anordnung vorliegen.

Nachteilig für die oben genannten Herstellungsverfahren ist, dass beispielsweise Photolithographie ein mehrstufiges und kostenintensives Verfahren ist, für welches zusätzliche Geräte erforderlich sind und bei dem ein signifikanter Anteil des verwendeten Metalls verloren geht. E-Lithographie ist ein noch teureres Herstellungsverfahren. Nachteilig ist hierbei auch, dass der Durchsatz relativ begrenzt ist. Kolloidale Lithographie (ein günstigeres Herstellungsverfahren) hingegen erzeugt normalerweise Nanopartikelarrays, bei denen die Nanopartikel kleiner sind als die maskierenden Partikel und deshalb nur einen geringen Flächenanteil erreichen.

Bei der Herstellung mittels Kern-Schale (CS)-Teilchen ist der maximale Durchmesser der Partikel, die sich in CS kompakte Nanopartikel zersetzen, derzeit mit 260 nm angegeben (Vogel et. al, Beilstein J. Nanotechnol. 2011, 2, 459). Diese Art der Herstellung beschränkt ebenfalls den möglichen maximalen Abstand zwischen den Nanopartikel.

Darüber hinaus erfordern monodisperse Kern-Schale (CS)-Teilchen eine regelmäßige Anordnung mit minimalen Abweichungen von der Kugelform. Letztere Bedingung ist jedoch schwer mit den zurzeit verwendeten CS-Teilchen-Synthesen zu erreichen.

Der Erfindung liegt daher die Aufgabe zugrunde, ein Verfahren zur Herstellung von Metall-Nanapartikel-Arrays zu entwickeln, durch welches ermöglicht werden soll, dass die Metall-Nanaopartikelgröße und der interpartikuläre Abstand zwischen den Metall-Nanopartikeln einstellbar sind.

Die Aufgabe wird erfindungsgemäß bei einem Verfahren zur Herstellung von Metall-Nanopartikel-Arrays dadurch gelöst, dass
- eine kolloidale Dispersion von Mikrosphären durch konvektive Anordnung als dicht gepackte Monoschicht auf einem Substrat abgeschieden wird,
- wonach die abgeschiedene Monoschicht mit mindestens einer dünnen abgeschiedenen Metall-Nanopartikel-Schicht mittels eines physikalischen Abscheideverfahrens beschichtet wird, und
- wonach die mit der mindestens einen Metall-Nanopartikel-Schicht beschichteten Mikrosphären, die auf dem Substrat als Monoschicht abgeschieden sind, mittels thermischer Zersetzung entfernt werden, wodurch die mindestens eine Metall-Nanopartikel-Schicht mit dem Substrat versintert wird.

Alternativ wird die Aufgabe erfindungsgemäß bei einem Verfahren zur Herstellung von Metall-Nanopartikel-Arrays dadurch gelöst, dass
- Mikrosphären mit mindestens einer diinnen abgeschiedenen Metall-Nanopartikel-Schicht mittels eines physikalischen Abscheideverfahrens beschichtet werden,
- wonach die mindestens mit einer Metall-Nanopartikel-Schicht beschichteten Mikrosphären kolloidal dispergiert werden,
- wonach die kolloidale Dispersion der mit einer Metall-Nanopartikel-Schicht beschichteten Mikrosphären durch konvektive Anordnung als dicht gepackte Monoschicht auf einem Substrat abgeschieden wird, und
- wonach die mit der mindestens einen Metall-Nanopartikel-Schicht beschichteten Mikrosphären, die auf dem Substrat als Monoschicht abgeschieden sind, mittels thermischer Zersetzung entfernt werden, wodurch die mindestens eine Metall-Nanopartikel-Schicht mit dem Substrat versintert wird.

Hierbei ist vorteilhaft vorgesehen, dass als Mikrospären monodisperse Polymerteilchen bzw. Polystyrol-Mikrokügelchen verwendet werden, die kommerziell erhältlich sind und daher keine zusätzlichen Herstellungskosten mit sich bringen.

Die Metall-Nanopartikel werden mittels eines physikalischen Abscheideverfahrens auf eine aus Mikrosphären dicht gepackte Monoschicht indirekt auf das Substrat aufgebracht, wobei das Verbinden der Metall-Nanopartikel mit dem Substrat durch thermische Zersetzung der aus Mikrosphären dicht gepackten Monoschicht erfolgt, sodass
- die Mikrosphären entfernt sind,
- die mindestens eine Metall-Nanopartikel-Schicht mit dem Substrat versintert ist,
- die Metall-Nanopartikel einen Durchmesser zwischen 100 nm und 1 µm und
- einen interpartikulären Abstand zwischen 50 nm und 1,5 µm aufweisen.

Der Begriff "indirekt" bedeutet hierbei, dass die Metall-Nanopartikel zwar auf die dicht gepackte Mikrosphären-Monoschicht abgeschieden werden, die Mikrosphären-Monoschicht jedoch durch thermische Zersetzung entfernt wird, wodurch die Metall-Nanopartikel auf dem Substrat gesintert werden.

Es ist erfindungsgemäß für die Metall-Nanopartikel-Arrays vorgesehen, dass die Metall-Nanopartikel-Schichtdicke zwischen 10 nm und 1 µm aufweist.

Die Dicke bestimmt die mechanische Stabilität und damit die Haftung der Metall-Nanopartikel in weiteren Bearbeitungsschritten, beeinflusst ihre optischen Eigenschaften und katalytische Aktivität.

Die Metall-Nanopartikel-Schichtdicken betragen zwischen 10 nm und 1µm, vorzugsweise zwischen 10 nm und 200 nm und besonders bevorzugt zwischen 40 nm und 100 nm. Die Metall-Nanopartikel-Schichtdicke beträgt bevorzugt zwischen 200 nm und 1 µm.

Eine weitere erfindungsgemäße Ausgestaltung der Metall-Nanopartikel-Arrays sieht vor, dass die Metall-Nanopartikel mindestens einen Durchmesser von 260 nm aufweisen.

Es ist jedoch auch möglich, dass die Metall-Nanopartikel mindestens einen Durchmesser von 300 nm aufweisen. Ebenfalls ist vorgesehen, dass die Metall-Nanopartikel mindestens einen Durchmesser von 320 nm aufweisen.

Größere Partikel erlauben durch reaktives Ionenätzen oder Metall-unterstütztes chemisches Ätzen die Herstellung entsprechend großer Löcher oder Drähte, wie sie für Antireflex-Beschichtungen oder biomimetische Haftoberflächen gebraucht werden.

Die Durchmesser der Metall-Nanopartikel können zwischen 100 nm und 1 µm liegen und derart gewählt werden, dass sie sichtbares oder infrarotes Licht effizient streuen oder effizient absorbieren.

Ebenfalls ist als eine bevorzugte Ausführungsform der Metall-Nanopartikel-Arrays vorgesehen, dass die Metall-Nanopartikel mindestens einen interpartikulären Abstand zwischen 50 nm und 1,5 µm aufweisen.

Durch Metall-Nanopartikel mit Durchmessern zwischen 100 nm und 1 µm, deren interpartikuläre Abstände zwischen 50 nm und 1.5 µm gewählt sind, kann erreicht werden, dass die Reflektion minimiert wird und die Transmission des Lichts in das Substrat optimal ist.

Partikel mit geringen Abständen sind bekanntermaßen nützlich für Katalyse, Optik und andere Bereiche wie beispielsweise die Erhöhung der Haftung biologischer Zellen und die gezielte Applikation pharmakologisch wirksamer Substanzen.

Flexibel einstellbare Abstände sind beispielsweise wichtig für die Strukturierung von Oxidsubstraten, wie Magnesiumoxid (MgO) oder Strontiumtitanat (SrTiO₃) sowie um Haftstellen ("pinning centers") für Typ-II-Supraleitende Dünnfilme aus Yttrium-Barium-Kupferoxid (YBCO) bereitzustellen.

Es ist ebenfalls zu der Erfindung gehörig, dass die interpartikulären Abstände zwischen 500 nm und 1.5 µm gewählt sind.

Vorteilhafterweise sind die interpartikulären Abstände größer 1 µm auch für die Herstellung von Halbleiterdrähten mit hohen Seitenverhältnissen durch "Vapor-Liquid-Solid-Growth" sowie für Reaktives Ionenätzen oder Metall-unterstütztes chemisches Ätzen.

Solche Drähte sind als Elektronenemitter, für die elektrische Kontaktierung, für neuartige Feldeffekttransistoren und andere Anwendungen nutzbar.

In analytischen Anwendungen (SERS etc.) haben die Partikel vorteilhaft Abstände, damit die optische Kopplung zwischen ihnen gering ist und die optischen Antworten der einzelnen Partikel einzeln ausgelesen werden.

Partikel mit Abständen unterhalb des Diffraktions-Limit sind schwer mit herkömmlichen Optiken aufzulösen. Dagegen können Partikel, die mit Abständen oberhalb des Diffraktions-Limits angeordnet sind, mit herkömmlichen optischen Methoden einzeln ausgelesen werden.

Vorteilhaft für die Metall-Nanopartikel-Arrays ist weiterhin, dass die Metall-Nanopartikel zueinander hexagonal angeordnet sind.

Dies ist vorteilhaft, da die hexagonale Anordnung die Fläche effizient ausnutzt sowie die Position der Nachbarpartikel stets bekannt ist.

Es ist jedoch auch vorstellbar, dass die Metall-Nanopartikel eine trigonale oder quadratische Anordnung aufweisen.

Vorteilhafterweise ist für das Verfahren zur Herstellung von Metall-Nanopartikel-Arrays sowie für die Metall-Nanopartikel-Arrays vorgesehen, dass die Mikrosphären einen Durchmesser zwischen 90 nm und 1,2 µm aufweisen.

Entsprechend der Anwendung ist ebenfalls vorgesehen, dass Mikrosphären verwendet werden, die einen Durchmesser zwischen 90 nm und 1200 nm, bevorzugt zwischen 200 nm und 1000 nm oder zwischen 1000 nm und 1200 nm aufweisen.

Eine weitere vorteilhafte Ausgestaltung für das Verfahren zur Herstellung von Metall-Nanopartikel-Arrays sowie für die Metall-Nanopartikel-Arrays sieht vor, dass das Substrat aus Silizium, Glas, Quarzglas, Einkristall, Saphir, Polyimid, Polytetrafluorethylen (PTFE) oder anderen Oxidmaterialien, Keramiken oder Metall besteht.

Andere Oxidmaterialien sind beispielsweise Magnesiumoxid (MgO) oder Strontiumtitanat (SrTiO₃).

Ebenfalls ist vorteilhaft für das Verfahren zur Herstellung von Metall-Nanopartikel-Arrays sowie für die Metall-Nanopartikel-Arrays selbst, dass das Substrat eine 2D-Oberfläche oder eine 3D-Oberfläche aufweist.

Dies bedeutet, dass das Substrat beispielsweise ein flaches zweidimensionales Objekt, aber auch eine gewölbte Oberfläche oder eine Oberfläche eines dreidimensionalen Körpers sein kann.

Durch diese Ausgestaltung der Erfindung können somit sowohl flache und herkömmliche (2D-) Nanopartikel-Arrays, als auch gekrümmte bzw. gewölbte (3D-)Nanopartikel-Arrays hergestellt werden. Gewölbte Nanopartikel-Arrays sind beispielsweise für optische Fasern, katalytische Konverter, implantierbare Elektroden und optische Linsen sinnvoll zu verwenden. Sie können auf bestehende Strukturen aufgebracht werden, um Selbstreinigung, Verzögerung des Vereisens oder Veränderung der optischen Transmission sowie das Reflexionsverhalten oder ein Reliefhologramm durch die regelmäßige Anordnung hervorzurufen.

Es ist vorteilhaft, dass das physikalische Abscheideverfahren Sputtern, Elektronenstrahl-Verdampfung, thermische Verdampfung oder gepulste Laserabscheidung ist.

Ebenfalls ist es für das Verfahren zur Herstellung von Metall-Nanopartikel-Arrays sowie für die Metall-Nanopartikel-Arrays vorgesehen, dass das Metall der Metall-Nanopartikel-Schicht oder der Metall-Nanopartikel ein Edelmetall ist.

Hierbei ist insbesondere vorteilhaft, dass das Edelmetall Gold (Au), Silber (Ag) oder Platin (Pt) ist.

Die Metalle Au und Pt können ohne weitere Vorkehrungen an Luft gesintert werden, ohne zu oxidieren. Alle drei Metalle weisen starke Oberflächenplasmonen auf, anhand derer das Array leicht charakterisiert werden kann. Zudem sind die Metalle katalytisch aktiv.

Zur einfacheren Handhabung ist vorteilhaft vorgesehen, dass die thermische Zersetzung in einem Ofen oder durch Verwendung einer Ethanolflamme erfolgt.

Natürlich kann auch jedes andere sinnvolle Verfahren angewendet werden, welches die thermische Zersetzung der Mikrosphären ermöglicht.

Besonders vorteilhaft ist für das Verfahren zur Herstellung von Metall-Nanopartikel-Arrays vorgesehen, dass der Anteil der ursprünglich eingesetzten Metall-Nanopartikel, der tatsächlich im Metall-Nanopartikel-Array eingebaut wird, zwischen 1 und 0,9 liegt.

Durch das Verfahren zur Herstellung wird ermöglicht, dass die verwendete Metallmenge zu nahezu 100 % auf den Array aufgebracht wird. Dies führt zu einer Herstellungskostenersparnis im Gegensatz zu den herkömmlichen Verfahren.

Während der Herstellung der Metall-Nanopartikel-Arrays können nicht erwünschte Metall-Nanopartikel-Substrukturen auftreten.

Daher ist erfindungsgemäß für das Verfahren zur Herstellung von Metall-Nanopartikel-Arrays vorgesehen, dass die während der Herstellung gebildeten Metall-Nanopartikel-Substrukturen nach der thermischen Zersetzung durch nass-chemisches Ätzen entfernt werden, wobei als Ätzlösung wässriges I₂/KI verwendet wird.

Ebenfalls ist es für das Verfahren zur Herstellung von Metall-Nanopartikel-Arrays sowie für die Metall-Nanopartikel-Arrays vorgesehen, dass das Versintern der Metall-Nanopartikel mit dem Substrat bei einer Temperatur zwischen 350 °C und 400 °C oder zwischen 500 °C und 700 °C stattfindet.

Die erfindungsgemäß hergestellten Metall-Nanopartikel-Arrays eigenen sich beispielsweise als
- Katalysatoren für das "vapor-liquid-solid (VLS)" Wachstum von Halbleiter-Nanodrähten,
- Katalysatoren für Metall-unterstützes Ätzen,
- Katalysatoren für die stromlose elektrolytische Beschichtung,
- Katalysatoren für die Zersetzung flüchtiger organischer Verbindungen (VOC),
- Katalysatoren für selbstreinigende Oberflächen,
- Optische Filter,
- Dreidimensionale Biofunktionalisierung von Oberflächen,
- Dekorative Beschichtungen,
- Substrate für "Surface Enhanced Raman Spectroscopy (SERS)"
- Infrarot-Absorber und -Reflektoren,
- Oberflächen für die Analytik mit Oberflächenplasmonen.

Nachfolgend wird die Erfindung anhand von Ausführungsbeispielen näher erläutert.

Es zeigen
- Fig. 1: a) eine schematische Darstellung eines Verfahrens zur Herstellung von MetallNanopartikel-Arrays, b) eine schematische Darstellung eines Verfahrens zur Herstellung von Metall-Nanopartikel-Arrays,
- Fig. 2: a) Rasterelektronenmikroskop-(REM)-Bild eines typischen Metall-NanopartikelArrays mit unerwünschten Metall-Nanopartikel-Substrukturen, b) REM-Bild eines typischen Metall-Nanopartikel-Arrays,
- Fig. 3: a) REM-Bild eines typischen Au-Nanopartikel-Arrays mit unerwünschten MetallNanopartikel-Substrukturen, der Silizium als Substrat aufweist, b) REM-Bild eines typischen Au-Nanopartikel-Arrays nach nass-chemischen Ätzen,
- Fig. 4 a-f: Beispiele für die Metall-Nanopartikel-Arrays, die durch Flammen-Annealing hergestellt wurden,
- Fig. 5 a-b: Metall-Nanopartikel-Arrays mit unterschiedlichen interpartikulären Abständen und verschiedenen Metallschichtdicken,
- Fig. 6 a-f: Beispiele für Goldnanopartikel mit unterschiedlichen Nanopartikeldurchmessern als Metall-Nanopartikel-Arrays, wobei als Substrat Silizium verwendet wurde,
- Fig. 7 a-c: Beispiele für Metall-Nanopartikel-Arrays, wobei verschieden Substrate verwendet wurden,
- Fig. 8: a) schematische Darstellung für metallbeschichtete Polymermultischichten und b) REM-Bild eines typischen Multischichten-Arrays.

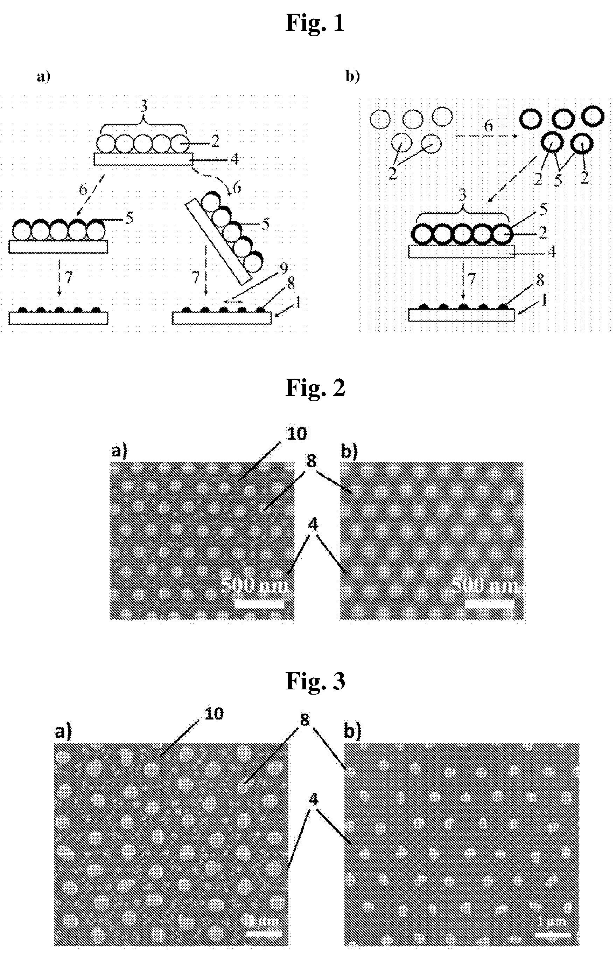

Fig. 1a) zeigt eine schematische Darstellung eines erfindungsgemäßen Verfahrens zur Herstellung von Metall-Nanopartikel-Arrays (1). In einem ersten Schritt wird eine kolloidale Dispersion von Mikrosphären (2) durch konvektive Anordnung als dicht gepackte Monoschicht (3) auf einem Substrat (4) abgeschieden. Hiernach wird die abgeschiedene Monoschicht (3) mit mindestens einer dünnen abgeschiedenen Metall-Nanopartikel-Schicht (5) mittels eines physikalischen Abscheideverfahrens (6) beschichtet. Das physikalische Abscheideverfahren (6) kann gegenüber der Monoschicht (3) im Senkrechteinfall (0°, siehe die linke Variante) oder in einem schrägen Einfall (vorzugsweise in einem Winkel zwischen 45° - 70°, jedoch nicht beschränkend darauf, siehe die rechte Variante in Fig. 1a)) erfolgen. Vor der Beschichtung kann die Metall-Nanopartikel-Schicht (5) bereits als Schicht vorliegen.

Es ist jedoch auch vorstellbar, dass die Metall-Nanopartikel (8) als feines Pulver, Dispersion oder in einer anderen Form vorliegen und derart aufgebracht werden, dass eine Metall-Nanopartikel-Schicht (5) auf der abgeschiedenen Monoschicht (3) entsteht. Nach der Beschichtung werden die mit der mindestens einen Metall-Nanopartikel-Schicht (5) beschichteten Mikrosphären (2), die auf dem Substrat (4) als Monoschicht (3) abgeschieden sind, mittels thermischer Zersetzung (7) entfernt.

Als weiteres erfindungsgemäßes Verfahren ist vorgesehen (schematisch in Fig. 1b) gezeigt), dass zuerst die Mikrosphären (2) mit mindestens einer dünnen abgeschiedenen Metall-Nanopartikel-Schicht (5) mittels eines physikalischen Abscheideverfahrens (6) beschichtet werden. Daraufhin werden die mindestens mit einer Metall-Nanopartikel-Schicht (5) beschichteten Mikrosphären (2) kolloidal dispergiert, wonach die kolloidale Dispersion der mit einer Metall-Nanopartikel-Schicht (5) beschichteten Mikrosphären (2) durch konvektive Anordnung als dicht gepackte Monoschicht (3) auf einem Substrat (4) abgeschieden wird. Nachfolgend auf diesen Schritt werden die mit der mindestens einen Metall-Nanopartikel-Schicht (5) beschichteten Mikrosphären (2), die auf dem Substrat (4) als Monoschicht (3) abgeschieden sind, mittels thermischer Zersetzung (7) entfernt.

Durch diese Verfahren werden, wie schematisch in den Figuren 1a) und 1b) gezeigt, Metall-Nanopartikel-Array (1), bestehend aus Metall-Nanopartikeln (8), die auf einem Substrat (4) aufgebracht sind, hergestellt. Die Metall-Nanopartikel (8) werden mittels eines physikalischen Abscheideverfahrens (6) auf eine aus Mikrosphären (2) dicht gepackte Monoschicht (3) indirekt auf das Substrat (4) aufgebracht. Das Verbinden (Annealing) der Metall-Nanopartikel (8) mit dem Substrat (4) erfolgt zugleich mit der thermischen Zersetzung (7) der aus Mikrosphären (2) dicht gepackten Monoschicht (3), wobei die Mikrosphären (2) dann entfernt sind, die mindestens eine Metall-Nanopartikel-Schicht (5) mit dem Substrat versintert ist, die Metall-Nanopartikel (8) einen Durchmesser zwischen 100 nm und 1 µm aufweisen und die Metall-Nanopartikel (8) einen interpartikulären Abstand (9) zwischen 50 nm und 1,5 µm aufweisen.

Wie in der Figur 2a) bis 2b) gezeigt ist, ist es von dem Einfall des physikalischen Abscheideverfahrens (6) gegenüber der Monoschicht (3) abhängig, ob unerwünschte Metall-Nanopartikel-Substrukturen (10) und Metall-Nanopartikel (8) oder nur die erwünschten Metall-Nanopartikel (8) nach der thermische Zersetzung (7) der Mikrosphären (2), wobei die thermische Zersetzung (7) in einem Ofen oder durch Verwendung einer Ethanolflamme erfolgen kann, mit bzw. auf einem Substrat (4) versintert sind. Wenn das physikalische Abscheideverfahren (6) im Senkrechteinfall (0°, siehe Figur 2a) erfolgt, entstehen Metall-Nanopartikel (8) sowie Metall-Nanopartikel-Substrukturen (10), die mit bzw. auf einem Substrat (4) versintert sind. Wenn das physikalische Abscheideverfahren (6) jedoch in einem schrägen Einfall (vorzugsweise in einem Winkel zwischen 45° - 70°, siehe Figur 2b) erfolgt, entstehen ausschließlich Metall-Nanopartikel (8), die mit bzw. auf einem Substrat (4) versintert sind. Daher ist es ebenfalls vorteilhaft vorgesehen, dass das physikalische Abscheideverfahren (6) in einem schrägen Einfall (vorzugsweise in einem Winkel zwischen 45° - 70°) erfolgt.

In der Fig. 3a) ist ein Rasterelektronenmikroskop-(REM)-Bild eines typischen Metall-Nanopartikel-Arrays (1) mit Metall-Nanopartikeln (8) sowie unerwünschten Metall-Nanopartikel-Substrukturen (10) dargestellt. Das Substrat (4) des Metall-Nanopartikel-Arrays (1) besteht im vorliegenden Beispiel aus Silizium. Das Metall wurde durch ein physikalisches Abscheideverfahrens (6) (hier Sputtern im Senkrechteinfall) auf die Mikrosphären (2) aufgebracht, wonach es bei 650 °C für eine Stunde mittels thermische Zersetzung (7) der Mikrosphären (2) mit dem Substrat (4) versintert wurde. Die thermische Zersetzung (7) kann in einem Ofen oder durch Verwendung einer Ethanolflamme erfolgen. Als Metall-Nanopartikel-Schicht (5) bzw. Metall-Nanopartikel (8) wurde Gold (Au) gewählt. Die Metall-Nanopartikel (8) sowie die Metall-Nanopartikel-Substrukturen (10) sind mit bzw. auf einem Substrat (4) versintert.

Da die Metall-Nanopartikel-Substrukturen (10) unerwünscht sind, können diese nach der thermischen Zersetzung (7) durch beispielsweise nass-chemisches Ätzen entfernt werden, wobei als Ätzlösung wässriges I2/KI:H₂O (1:10) verwendet wird. Ein Metall-Nanopartikel-Array (1) mit Gold als Metall und Silizium als Substrat (4) ist nach dem nass-chemischen Ätzen und daher ohne die unerwünschten Metall-Nanopartikel-Substrukturen (10) in Fig. 3b) dargestellt.

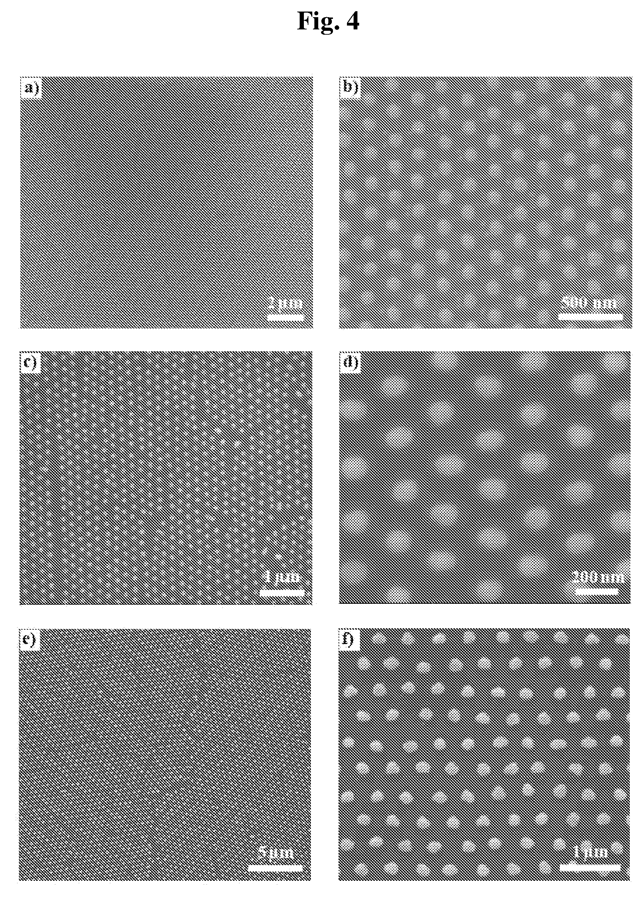

Die thermische Zersetzung (7) der Mikrosphären (2) und das Versintern (Verbinden oder auch Annealing) funktioniert sowohl in einem Ofen als durch Verwendung einer Ethanolflamme, wobei letzteres, unabhängig davon welche Seite des zu versinternen Metall-Nanopartikel-Arrays (1) in die Ethanolflamme gehalten wird, wesentlich schneller erfolgt (< 2 min). Beispiele für hergestellte Metall-Nanopartikel-Arrays (1) unter Verwendung einer Ethanolflamme für 2 Minuten sind in den Figuren 4a) bis 4f) dargestellt. Die Figuren 4a) und 4b) zeigen hierbei Metall-Nanopartikel-Arrays (1), wobei Gold (Au) als Metall-Nanopartikel-Schicht (5) bzw. Metall-Nanopartikel (8) ausgewählt wurde. Das Substrat (4) der Metall-Nanopartikel-Arrays (1) bestand für die in den Figuren 4a) und 4b) dargestellten Arrays (1) aus Quarzglas. Die Figuren 4c) und 4d) zeigen hierbei Metall-Nanopartikel-Arrays (1), wobei Platin (Pt) als Metall-Nanopartikel-Schicht (5) bzw. Metall-Nanopartikel (8) ausgewählt wurde. Das Substrat (4) der Metall-Nanopartikel-Arrays (1) bestand ebenfalls aus Quarzglas. In den Figuren 4a) bis 4d) wurde die Etanolflamme auf der Vorderseite der Metall-Nanopartikel-Arrays (1) gerichtet. Die Figuren 4e) und 4f) zeigen hierbei Metall-Nanopartikel-Arrays (1), wobei Platin (Pt) als Metall-Nanopartikel-Schicht (5) bzw. Metall-Nanopartikel (8) ausgewählt wurde. Das Substrat (4) der Metall-Nanopartikel-Arrays (1) war hier jedoch Silizium. In den Figuren 4e) und 4f) wurde die Etanolflamme auf der Rückseite der Metall-Nanopartikel-Arrays (1) gerichtet.

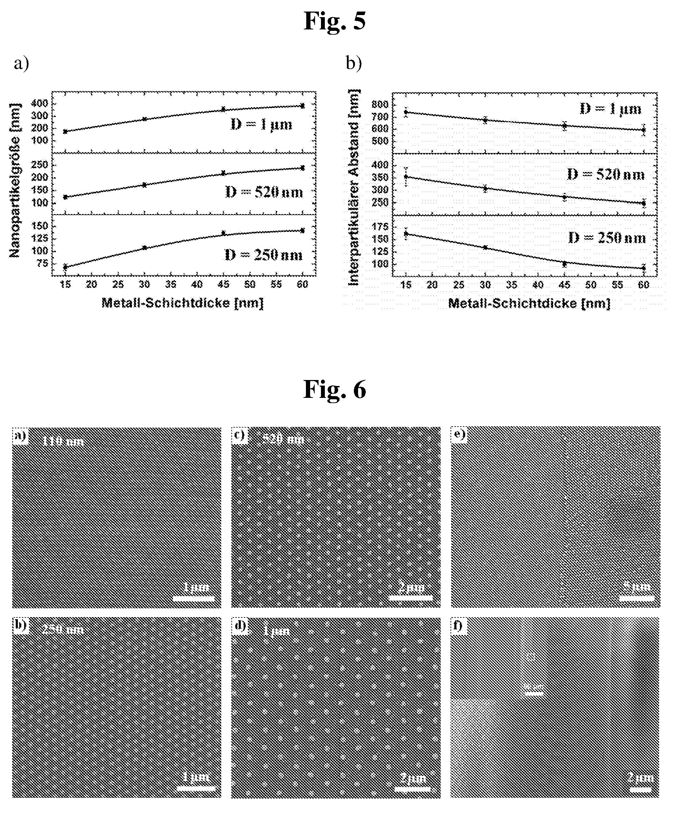

Die Größe und die interpartikulären Abstände (9) der Metall-Nanopartikel (8) kann über die Dicke der Metall-Nanopartikel-Schicht (5) und den Durchmesser (D) der Mikrosphären (2) eingestellt werden. Hierbei korreliert das Volumen der Metall-Nanopartikel-Schicht (5) auf jeder einzelnen Mikrosphäre (2) mit der Größe des versinterten Metall-Nanopartikels (8). Der Einfluss des Durchmessers (d) der Mikrosphären (2) sowie der Einfluss der Dicke der Metall-Nanopartikel-Schicht (5) auf die Größe der Metall-Nanopartikel (8) und den interpartikulären Abstände (9) der Metall-Nanopartikel (8) ist in Figur 5 a) bis b) dargestellt.

Durch Mikrosphären (2) mit Durchmessern (D) zwischen 110 nm und 1 µm werden Metall-Nanopartikel-Arrays (1) mit enger Größenverteilung ermöglicht. In der Figur 6 a) bis d) sind REM-Aufnahmen von Metall-Nanopartikel-Arrays (1) auf Silizium als Substrat (4) von Monoschichten (3) aus Mikrosphären (2) mit unterschiedlichen Durchmessern (D) dargestellt. Die Durchmesser (D) der Mikrosphären (2) sind für Fig. 6a) 110 nm, für Fig. 6b) 250 nm, für Fig. 6c) 520 nm und für Fig. 6d) 1 um. Die Monoschicht (3) wurde mit Gold (Au) bei 45 ° Inzidenz gesputtert und anschließend bei 700 °C für 1 h versintert. Figur 6e) zeigt den Unterschied zwischen stochastischen Partikeln, die durch Entnetzung der anfänglichen Metallschicht, die auf blanken Untergrund abgeschieden wurde, erzeugt wurden (links in Fig. 6e)) und geordneten Partikeln, die nach thermischer Zersetzung (7) der Metall-beschichteten Mikrosphären-Monoschicht, hergestellt wurden (rechts in Fig. 6e)). Der hier vorgeschlagene Ansatz ist nicht auf flache Substrate (4) begrenzt: 3D-Objekte können ebenfalls strukturiert werden. Dies ist beispielhaft in Fig. 6f) gezeigt. Ein Glasrohr (Durchmesser = 180 um) wurde mit Metall(Gold)-Nanopartikeln (8) nach der Zersetzung (7) der durch Tauchbeschichtung aufgebrachten Mikrosphären-Monoschicht mit einem Muster versehen. Die Mikrosphären (2) weisen hierbei einen Durchmesser (D) von 520 nm auf. Der Einschub in Fig. 6f) ist eine Vergrößerung des ausgewählten Bereichs auf der Oberfläche des Rohres.

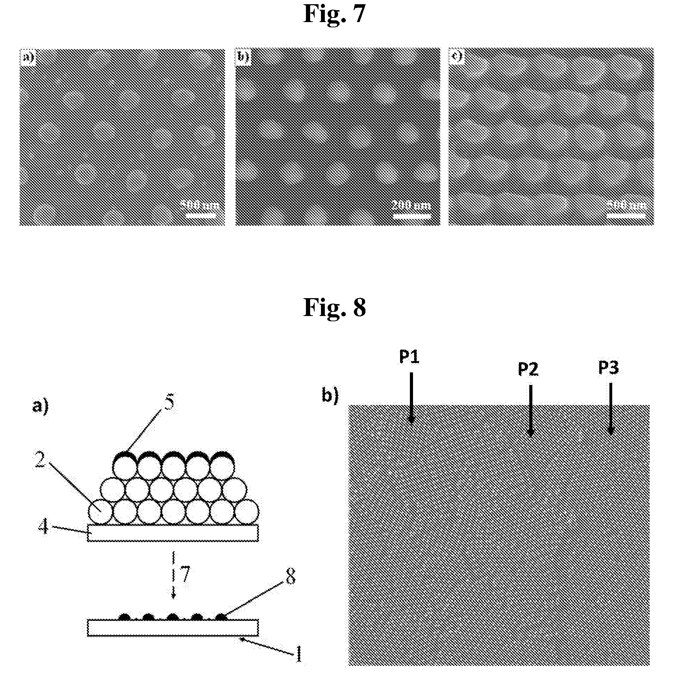

Weiterhin ist es möglich, dass Metall-Nanopartikel-Arrays (1) auf anderen Substraten (4) bzw. Substrattypen wie Quarzglas (Fig. 7a)), Saphir (Fig. 7b)) oder Polyimid (Fig. 7c)) hergestellt werden. Beispielhaft sind für diese Substrate REM-Aufnahmen in der Figur 7 a) bis c) dargestellt. Die Versinterungstemperatur hängt sowohl von dem zu verwendenden Metall und als auch von dem Typ des Substrats (4) ab. Temperaturen im Bereich von 500-700 °C wurden für Silizium-, Saphir- und Quarzsubstrate verwendet. Obwohl die Verfahren besonders gut bei diesen (höheren) Temperaturen funktionieren, können sie auch für Substrate mit einem begrenzten thermischen Budget verwendet werden. Zum Beispiel Substrate (4) aus Polyimid können bei 380 °C, was unterhalb der Glasübergangstemperatur von Polyimid liegt, versintert werden. Glas-, Mica-, Metall-, Keramiken- oder Oxidmaterialien sind ebenfalls als Substrate (4) verwendbar.

Dass die Verfahren zur Herstellung von Metall-Nanopartikel-Arrays (1) nicht nur auf Monoschichten (3) aus Mikrosphären (2) anwendbar sind, ist in der Fig. 8 a) - b) gezeigt. Oben in Figur 8a) ist schematisch eine Multischicht (hier drei Schichten) dargestellt, wobei die oberste Monoschichten (3) aus Mikrosphären (2) mit einer Metall-Nanopartikel-Schicht (5) beschichtet ist. Nach der thermischen Zersetzung (7) der Mikrosphären (2) und dem Versintern (Verbinden oder auch Annealing) entsteht ebenfalls ein Metall-Nanopartikel-Array (1). Dieser Metall-Nanopartikel-Arrays (1) ist als REM-Aufnahme in Fig. 8b) gezeigt. Pfeil 1 (P1) zeigt hierbei Metall-Nanopartikel (8) der dritten Schicht, Pfeil 2 (P2) Metall-Nanopartikel (8) der zweiten Schicht und Pfeil 3 (P3) Metall-Nanopartikel (8) der ersten Schicht.

## Patentansprüche

1. Verfahren zur Herstellung von Metall-Nanopartikel-Arrays (1), **dadurch gekennzeichnet, dass**
- eine kolloidale Dispersion von Mikrosphären (2) durch konvektive Anordnung als dicht gepackte Monoschicht (3) auf einem Substrat (4) abgeschieden wird,
- wonach die abgeschiedene Monoschicht (3) mit mindestens einer dünnen abgeschiedenen Metall-Nanopartikel-Schicht (5) mittels eines physikalischen Abscheideverfahrens (6) beschichtet wird, und
- wonach die mit der mindestens einen Metall-Nanopartikel-Schicht (5) beschichteten Mikrosphären (2), die auf dem Substrat (4) als Monoschicht (3) abgeschieden sind, mittels thermischer Zersetzung (7) entfernt werden, wodurch die mindestens eine Metall-Nanopartikel-Schicht (5) mit dem Substrat versintert wird.

2. Verfahren zur Herstellung von Metall-Nanopartikel-Arrays (1), **dadurch gekennzeichnet, dass**
- Mikrosphären (2) mit mindestens einer dünnen abgeschiedenen Metall-Nanopartikel-Schicht (5) mittels eines physikalischen Abscheideverfahrens (6) beschichtet werden,
- wonach die mindestens mit einer Metall-Nanopartikel-Schicht (5) beschichteten Mikrosphären (2) kolloidale dispergiert werden,
- wonach die kolloidale Dispersion der mit einer Metall-Nanopartikel-Schicht (5) beschichteten Mikrosphären (2) durch konvektive Anordnung als dicht gepackte Monoschicht (3) auf einem Substrat (4) abgeschieden wird, und
- wonach die mit der mindestens einen Metall-Nanopartikel-Schicht (5) beschichteten Mikrosphären (2), die auf dem Substrat (4) als Monoschicht (3) abgeschieden sind, mittels thermischer Zersetzung (7) entfernt werden, wodurch die mindestens eine Metall-Nanopartikel-Schicht (5) mit dem Substrat versintert wird.

3. Verfahren gemäß Anspruch 1 oder Anspruch 2, **dadurch gekennzeichnet, dass** die Metall-Nanopartikel-Schicht eine Schichtdicke zwischen 10 nm und 1 µm aufweist.

4. Verfahren gemäß Anspruch 1 oder Anspruch 2, **dadurch gekennzeichnet, dass** die Metall-Nanopartikel (8) mindestens einen Durchmesser von 260 nm aufweisen.

5. Verfahren gemäß Anspruch 1 oder Anspruch 2, **dadurch gekennzeichnet, dass** die Metall-Nanopartikel (8) mindestens einen interparühulären Abstand (9) von 500 nm aufweisen.

6. Verfahren gemäß Anspruch 1 oder Anspruch 2, **dadurch gekennzeichnet, dass** die Metall-Nanopartikel (8) zueinander hexagonal angeordnet sind.

7. Verfahren gemäß Anspruch 1 oder Anspruch 2, **dadurch gekennzeichnet, dass** die Mikrosphären (2) einen Durchmesser zwischen 90 nm und 1,2 µm aufweisen.

8. Verfahren gemäß Anspruch 1 oder Anspruch 2, **dadurch gekennzeichnet, dass** das Substrat (4) aus Silizium, Glas, Quarzglas, Einkristall, Saphir, Polyimid, Polytetrafluorethylen (PTFE) oder anderen Oxidmaterialien, Keramiken oder Metall besteht.

9. Verfahren gemäß Anspruch 1 oder Anspruch 2, **dadurch gekennzeichnet, dass** das Substrat (4) eine 2D-Oberfläche oder eine 3D-Oberfläche aufweiset,

10. Verfahren gemäß Anspruch 1 oder Anspruch 2, **dadurch gekennzeichnet, dass** das physikalische Abscheideverfahren (6) Sputtern, Elektronenstrahl-Verdampfung, thermische Verdampfung oder gepulste Laserabscheidung ist.

11. Verfahrens gemäß Anspruch 1 oder Anspruch 2, **dadurch gekennzeichnet, dass** das Metall der Metall-Nanopartikel-Schicht (5) oder der Metall-Nanopartikel (8) ein Edelmetall ist.

12. Verfahren gemäß Anspruch 11, **dadurch gekennzeichnet, dass** das Edelmetall Gold (Au), Silber (Ag) oder Platin (Pt) ist.

13. Verfahren gemäß Anspruch 1 oder Anspruch 2, **dadurch gekennzeichnet, dass** die thermische Zersetzung (7) in einem Ofen oder durch Verwendung einer Ethanolflamme erfolgt.

14. Verfahren gemäß Anspruch 1 oder Anspruch 2, **dadurch gekennzeichnet, dass** der Anteil der ursprünglich eingesetzten Metall-Nanopartikel (8), der im Metall-Nanopartikel-Array (1) eingebaut wird, zwischen 1 und 0,9 liegt.

15. Verfahren gemäß Anspruch 1 oder Anspruch 2, **dadurch gekennzeichnet, dass** während der Herstellung gebildeten Metall-Nanopartikel-Substrükturen (10) nach der thermischen Zersetzung (7) durch nass-chemisches Ätzen entfernt werden, wobei als Ätzlösung wässriges I₂/KI verwendet wird.

16. Verfahren gemäß Anspruch 1 oder Anspruch 2, **dadurch gekennzeichnet, dass** das Versintern der Metall-Nanopartikel (8) mit dem Substrat (4) bei einer Temperatur zwischen 350 °C und 400 °C oder zwischen 500 °C und 700 °C stattfindet.

## Claims

1. Method of producing metal-nanoparticle arrays (1), **characterised in that**
• a colloidal dispersion of microspheres (2) is deposited on a substrate (4) as a densely packed monolayer (3) via convective assembly,
• after which the deposited monolayer (3) is coated with at least one thinly deposited metal-nanoparticle layer (5) by means of a physical deposition process (6), and
• after which the microspheres (2) coated with the at least one metal-nanoparticle layer (5) and deposited on the substrate (4) as a monolayer (3) are removed by thermal decomposition (7), as a result of which the at least one metal-nanoparticle layer (5) is sintered with the substrate.

2. Method of producing metal-nanoparticle arrays (1), **characterised in that**
• microspheres (2) are coated with at least one thinly deposited metal-nanoparticle layer (5) by means of a physical deposition process (6),
• after which the microspheres (2) coated with at least one metal-nanoparticle layer (5) are dispersed colloidally,
• after which the colloidal dispersion of microspheres (2) coated with a metal-nanoparticle layer (5) is deposited on a substrate (4) as a densely packed monolayer (3) by convective assembly, and
• after which the microspheres (2) coated with the at least one metal-nanoparticle layer (5) and deposited on the substrate (4) as a monolayer (3) are removed by thermal decomposition (7), as a result of which the at least one metal-nanoparticle layer (5) is sintered with the substrate.

3. Method according to claim 1 or claim 2, **characterised in that** the metal-nanoparticle layer has a thickness of between 10 nm and 1 µm.

4. Method according to claim 1 or claim 2, **characterised in that** the metal nanoparticles (8) have a diameter of at least 260 nm.

5. Method according to claim 1 or claim 2, **characterised in that** the metal nanoparticles (8) have an interparticle distance (9) of at least 500 nm.

6. Method according to claim 1 or claim 2, **characterised in that** the metal nanoparticles (8) are arranged in hexagonal arrays.

7. Method according to claim 1 or claim 2, **characterised in that** the microspheres (2) have a diameter of between 90 nm and 1.2 µm.

8. Method according to claim 1 or claim 2, **characterised in that** the substrate (4) consists of silicon, glass, quartz glass, a monocrystal, sapphire, polyimide, polytetrafluoroethylene (PTFE) or other oxidic materials, ceramics or metal.

9. Method according to claim 1 or claim 2, **characterised in that** the substrate (4) has a 2- D surface or a 3-D surface.

10. Method according to claim 1 or claim 2, **characterised in that** the physical deposition method (6) is sputtering, electron beam evaporation, thermal evaporation or pulsed laser deposition.

11. Method according to claim 1 or claim 2, **characterised in that** the metal of the metal-nanoparticle layer (5) or of the metal nanoparticles (8) is a precious metal.

12. Method according to claim 11, **characterised in that** the precious metal is gold (Au), silver (Ag) or platinum (Pt).

13. Method according to claim 1 or claim 2, **characterised in that** thermal decomposition (7) is conducted in a furnace or by using an ethanol flame.

14. Method according to claim 1 or claim 2, **characterised in that** between 90 and 100 % of the metal nanoparticles (8) used initially are incorporated in the metal-nanoparticle array (1).

15. Method according to claim 1 or claim 2, **characterised in that** metal-nanoparticle substructures (10) formed during production are removed following thermal decomposition (7) by means of wet-chemical etching, aqueous I₂/KI being used as etching solution.

16. Method according to claim 1 or claim 2, **characterised in that** the metal nanoparticles (8) are sintered with the substrate (4) at a temperature of between 350 °C and 400 °C or between 500 °C und 700 °C.

## Revendications

1. Procédé de fabrication de réseaux de nanoparticules métalliques (1), **caractérisé en ce que**
- une dispersion colloïdale de microsphères (2) est déposée par distribution par convection sur un substrat (4) sous forme d'une monocouche dense (3),
- puis la monocouche déposée (3) est revêtue d'au moins une couche mince de nanoparticules métalliques (5) déposées au moyen d'un procédé de dépôt physique (6), et
- puis les microsphères (2) déposées sur le substrat (4) sous forme d'une monocouche (3) et revêtue d'au moins une couche de nanoparticules métalliques (5) sont éliminées par décomposition thermique (7), la au moins une couche de nanoparticules métalliques (5) étant ainsi agglomérée par frittage avec le substrat.

2. Procédé de fabrication de réseaux de nanoparticules métalliques (1), **caractérisé en ce que**
- des microsphères (2) sont revêtues au moyen d'un procédé de dépôt physique (6) d'au moins une couche mince de nanoparticles métalliques (5) déposées,
- puis les microsphères (2) revêtues d'au moins une couche de nanoparticules métalliques (5) sont dispersées de manière colloïdale,
- puis la dispersion colloïdale de microsphères (2) revêtues d'une couche de nanoparticules métallique (5) est déposée sur un substrat (4) sous la forme d'une monocouche (3) dense par distribution par convection, et
- ensuite les microsphères (2) revêtus de la au moins une couche de nanoparticules métalliques (5) et déposées sur le substrat (4) sous forme d'une monocouche (3) sont éliminés par décomposition thermique (7), la au moins une couche de nanoparticules métalliques (5) étant ainsi agglomérée par frittage avec le substrat.

3. Procédé selon la revendication 1 ou la revendication 2, **caractérisé en ce que** la couche de nanoparticules métalliques a une épaisseur comprise entre 10 nm et 1 µm.

4. Procédé selon la revendication 1 ou la revendication 2, **caractérisé en ce que** les nanoparticles métalliques (8) présentent un diamètre d'au moins 260 nm.

5. Procédé selon la revendication 1 ou 2, **caractérisé en ce que** les nanoparticules métalliques (8) présentent une distance (9) entre particules d'au moins 500 nm.

6. Procédé selon la revendication 1 ou la revendication 2, **caractérisé en ce que** les nanoparticules métalliques (8) sont disposées entre elles selon un réseau hexagonal.

7. Procédé selon la revendication 1 ou la revendication 2, **caractérisé en ce que** microsphères (2) présentent un diamètre compris entre 90 nm et 1,2 µm.

8. Procédé selon la revendication 1 ou la revendication 2, **caractérisé en ce que** le substrat (4) est composé de silicium, de verre, de verre de quartz, d'un monocristal, de saphir, de polyimide, de polytétrafluoroéthylène (PTFE) ou d'autres matériaux de type oxyde, de céramiques ou de métaux.

9. Procédé selon la revendication 1 ou la revendication 2, **caractérisé en ce que** le substrat (4) présente une surface en deux dimensions ou une surface en trois dimensions.

10. Procédé selon la revendication 1 ou la revendication 2, **caractérisé en ce que** le procédé de dépôt physique (6) est une pulvérisation cathodique, une évaporation par faisceau d'électrons, une évaporation thermique ou un dépôt par laser pulsé.

11. Procédé selon la revendication 1 ou la revendication 2, **caractérisé en ce que** le métal de la couche de nanoparticules métalliques (5) ou des nanoparticules métalliques (8) est un métal noble.

12. Procédé selon la revendication 11, **caractérisé en ce que** le métal noble est de l'or (Au), de l'argent (Ag) ou du platine (Pt).

13. Procédé selon la revendication 1 ou la revendication 2, **caractérisé en ce que** la décomposition thermique (7) est réalisée dans un four ou en utilisant une flamme d'éthanol.

14. Procédé selon la revendication 1 ou la revendication 2, **caractérisé en ce que** la quantité de nanoparticules métalliques (8) utilisées initialement et incorporées dans le réseau de nanoparticules métalliques (1) est comprise entre 90 et 100%.

15. Procédé selon la revendication 1 ou la revendication 2, **caractérisé en ce que** les sous-structures de nanoparticules métalliques (10) formées pendant la fabrication sont éliminés après la décomposition thermique (7) par corrosion chimique par voie humide, de I'I₂/KI aqueux étant utilisé comme solution corrodante.

16. Procédé selon la revendication 1 ou la revendication 2, **caractérisé en ce que** frittage des nanoparticules métalliques (8) avec le substrat (4) est réalisé à une température comprise entre 350 °C et 400 °C ou entre 500 °C et 700 °C.
